# EUROPÄISCHE PATENTANMELDUNG

(11) **EP 1 809 087 A2**
(43) Veröffentlichungstag der Anmeldung: **18.07.2007**
(21) Anmeldenummer: 07100456.8
(22) Anmeldetag: 12.01.2007
(51) Int. Cl.: H05K 13/04

(54) **Verfahren und Vorrichtung zur Koplanaritätsmessung von Bauelementanschlüssen**

(30) Priorität: 13.01.2006 DE 102006001853
(71) Anmelder: SIEMENS AKTIENGESELLSCHAFT, 80333 München (DE)
(72) Erfinder: Besch, Karl-Heinz, 82140, Olching (DE); Hedrich, Matthias, 82515, Wolfratshausen (DE); Neumaier, Klaus, 81369, München (DE)

(57) **Zusammenfassung**

Die vorliegende Erfindung beschreibt Vorrichtung zur Lagevermessung von Bauelementanschlüssen (32, 232, 432, 532) eines Bauelements (30, 230),
mit einem Laser (40, 240, 440, 540) zum Ausstrahlen von Laserlicht (42, 242, 542), insbesondere eines Laserstrahls (42, 242, 542), in Richtung der Bauelementanschlüsse (32, 232, 432, 532),
mit einer Kamera (50, 250, 450, 550) zum Aufnehmen von Bilddaten des von den Bauelementanschlüssen (32, 232, 432, 532) rückgestreuten Lichts (44, 244),
mit einer Bildauswerteeinrichtung (350) zur Bestimmung der Lage der Bauelementanschlüsse (32, 232, 432, 532) mittels der Bilddaten, insbesondere zur Höhenbestimmung und/oder Koplanaritäts-Überprüfung der Bauelementanschlüsse (32, 232, 432, 532),
wobei Laser (40, 240, 440, 540) und Kamera (50, 250, 450, 550) in Bezug auf eine Mittelachse (238, 538) der Bauelementanschlüsse (32, 232, 432, 532) oder in Bezug auf eine Oberflächennormale (238, 538) des Bauelements (30, 230) auf einer Seite angeordnet sind.

## Beschreibung

Um den steigenden Anforderungen an die Zuverlässigkeit des Bestückprozesses von oberflächenmontierbaren Bauelementen (Surface Mounted Devices: SMD) gerecht zu werden, kontrolliert man zunehmend die Koplanarität hochpoliger Bauteile direkt vor dem Bestückvorgang. Eine solche Prüfung muss in sehr kurzer Zeit durchgeführt werden können, um die Bestückleistung möglichst wenig zu beeinträchtigen. Die Koplanarität von bestimmten SMD-Bauelementen, wie beispielsweise so genannten Small Outline Packages: SOPs oder Quad Flat Packages: QFPs, kann z.B. bestimmt werden, indem man sie über einen Lasertriangulationssensors fährt.

Aus dem Stand der Technik sind Vorrichtungen zu Koplanaritätsmessungen von Bauelementanschlüssen eines Bauelements bekannt, bei welchen ein Laserstrahl in Richtung der Bauelementanschlüsse ausgestrahlt wird und das durch diese rückgestreute Licht von einem lichtempfindlichen Sensor aufgenommen und analysiert wird. Eine solche Vorrichtung ist beispielsweise in der Europäischen Veröffentlichungsschrift EP 1 089 607 A2 offenbart.

Es ist ein Nachteil des Standes der Technik, dass bei diesen Verfahren, insbesondere auch bei der Analyse so genannter "Ball Grid Arrays" (BGA), also kugelförmige Anschlusselemente, die Gefahr einer spiegelnden Reflexion des Laserstrahls in Richtung der Kamera nicht zu vernachlässigen ist. Solche spiegelden Reflexionen können aber die Auswertung der Höhenmessungen der Anschlusselemente stark beeinträchtigt.

Daher ist es Aufgabe der vorliegenden Erfindung, eine Vorrichtung und ein Verfahren zur Verfügung zu stellen, mit welchem die Gefahr der spiegelnden Reflexion des Laserstrahls in Richtung der Kamera reduziert wird.

Diese Aufgabe wird beispielsweise gelöst durch eine Vorrichtung zur Lagevermessung von Bauelementanschlüssen eines Bauelements, mit einem Laser zum Ausstrahlen von Laserlicht, insbesondere eines Laserstrahls in Richtung der Bauelementanschlüsse,
mit einer Kamera zum Aufnehmen von Bilddaten des von den Bauelementanschlüssen rückgestreuten Lichts,
mit einer Bildauswerteeinrichtung zur Bestimmung der räumlichen Lage der Bauelementanschlüsse mittels der Bilddaten, insbesondere zur Höhenbestimmung und/oder zur Koplanaritätsüberprüfung der Bauelementanschlüsse, wobei Laser und Kamera in Bezug auf eine Mittelachse der Bauelementanschlüsse und/oder in Bezug auf eine Oberflächennormale des Bauelements auf einer Seite angeordnet sind.

Bei einem Bauelementanschluss mit einem ebenen Kontaktbereich kann die Mittelachse der Bauelementanschlüsse z.B. eine Oberflächennormale zu der Oberfläche dieses Kontaktbereichs sein. Bei einem Bauelementanschluss mit einer gekrümmten Oberfläche, beispielsweise eines Bauelementanschlusses in der Form einer Kugel oder eines Kugelabschnitts (z.B. ein sogenannter "Ball" eines BGA), kann die Mittelachse z.B. eine Rotations-oder Spiegel-Symmetrieachse des Bauelementanschlusses sein.

Die Oberflächennormale des Bauelements kann zum Beispiel eine Achse senkrecht auf eine Unterseite oder Oberseite des Bauelements sein, an welchem der Bauelementanschluss angebracht ist.

Wir in der folgenden Beschreibung nur die Mittelachse erwähnt, so ist damit ebenfalls die genannte Oberflächennormale umfasst, und umgekehrt.

Der Laser und die Kamera können in Bezug auf die Mittelachse und/oder die Oberflächennormale auf einer Seite z.B. derart angeordnet sein, dass die durch den Laser und die Mittelachse (bzw. die Oberflächennormale) aufgespannte "Einfallsebene" und die durch die Kamera und die Mittelachse (bzw. die Oberflächennormale) aufgespannte "Ausfallsebene" zueinander einen Winkel aufspannen, der kleiner oder gleich 90 Grad ist. Zur weiteren Verminderung der Wahrscheinlichkeit von Reflexen in die Kamera kann dieser Winkel auch kleiner oder gleich 45 Grad gewählt sein. In einer weiter bevorzugten Ausführungsform ist der Winkel zwischen Einfalls- und Ausfallsebene kleiner oder gleich 5 Grad. Die Einfalls- und Ausfallsebene können auch im wesentlichen identisch sein.

Dadurch, dass Laser und Kamera auf einer Seite der genannten Mittelachse und/oder der genannten Oberflächennormalen angeordnet sind, wird die Gefahr vermindert, dass insbesondere vom Kontaktbereich des Bauelementanschlusses ein spiegelnder Reflex des ausgesandten Laserlichts in die Kamera reflektiert wird. Diese Aussage trifft zumindest für alle gängigen Bauelementanschluss-Formen zu. Solche Bauelementanschlüsse können beispielsweise im Bereich der Kontaktfläche eben sein, wie zum Beispiel bei so genannten "Gullwing-Leads". Die Kontaktflächen können aber auch gekrümmt ausgebildet sein. Insbesondere können die Bauelementanschlüsse im Wesentlichen die Form von Kugeln oder von Kugelbereichen (z.B. Halbkugeln oder Viertelkugeln) haben, so dass die Kontaktbereiche die Form eines Kugelabschnitts haben können. Dies ist z.B. bei so genannten "Ball Grid Arrays" (BGA) der Fall.

Insbesondere bei derartigen Bauelementanschlüssen wird durch die vorstehend genannte Vorrichtung das Auftreten von spiegelnder Reflexion des ausgesandten Laserlichts in die Kamera erheblich reduziert, im Wesentlichen vermieden.

Wenn innerhalb der vorliegenden Beschreibung von einer kugelförmigen Oberfläche die Rede ist, so sind damit auch Oberflächen in der Form von Kugelabschnittsoberflächen gemeint. Zudem sind mit dem Wort "kugelförmig" nicht nur streng geometrische Kugelformen sondern auch kugelähnliche Formen (z.B. ellipsoide Formen) gemeint.

Bauelemente können z.B. elektronische Bauelemente mit metallischen Bauelementanschlüssen sein, wobei die Bauelementanschlüsse beispielsweise als Drähte oder metallischen Kontaktpunkte oder Kontaktkugeln ausgebildet sein können. Die Kontaktflächen der Bauelementanschlüsse können z.B. zur Kontaktierung der Bauelement an eine gedruckte oder ähnliche Schaltungsplantine (z.B. PCB: Printed Circuit Board) oder an eine vergleichbare elektronische Schaltung vorgesehen sein.

Insbesondere können weiterhin der Laser und die Kamera derart angeordnet sein, dass aus einem möglichst großen Bereich um die Kontaktflächen der Bauelementanschlüsse herum keine spiegelnde Reflexion des Laserlichts in die Kamera auftritt.

Mittels der genannten Vorrichtung können beispielsweise 3D-Daten der Bauelementanschlüsse oder der Kontaktbereiche der Bauelementanschlüsse ermittelt werden. Weiterhin kann die Vorrichtung zur Koplanaritätsüberprüfung von Bauelementanschlüssen herangezogen werden. Dabei kann z.B. ermittelt werden, ob die Kontaktflächen mehrerer Bauelementanschlüsse eines Bauelements sich in einer Ebene befinden, insbesondere sich in der Ebene einer Leiterplatte befinden, auf welchem das Bauelement angebracht werden soll oder angebracht wurde.

Weiterhin können Laser und Kamera in Bezug auf eine Mittelachse der Bauelementanschlüsse derart auf einer Seite angeordnet sein, dass zumindest aus einem Kontaktbereich der Bauelementanschlüsse keine spiegelnde Reflexion des ausgestrahlten Laserlichts in die Kamera auftritt.

Das Laserlicht kann beispielsweise als punktförmiger Laserstrahl ausgebildet sein. Ein solcher Laserstrahl führt zu einer punktförmigen Beleuchtung einer Oberfläche, wobei die Größe dieses Punkts dem Strahlquerschnitt des Laserstrahls entspricht. Dabei kann der Querschnitt des Laserstrahls beispielsweise kleiner als die Oberfläche eines Bauelementanschlusses sein.

Die Kamera kann weiterhin als Zeilenkamera ausgebildet sein. Eine solche Kamera kann z.B. einen lichtempfindlichen Sensor umfassen, der als Zeilensensor ausgebildet. Diese Ausgestaltung kann insbesondere bei der Verwendung eines punktförmigen Laserstrahls gemäß der vorangegangenen Beschreibung vorteilhaft sein.

Bei der Verwendung eines punktförmigen Laserstrahls mit einer Zeilenkamera kann beispielsweise zur Bestimmung der 3D-Daten von Bauelementanschlüssen eines Bauelements das Bauelement relativ zu Kamera und Laser derart bewegt werden, dass der durch den Laserstrahl auf der Oberfläche der Bauelementanschlüsse gebildete Lichtpunkt die gesamten Kontaktbereiche der zu vermessenden Bauelementanschlüsse überstreicht.

Mittels eines Triangulationsverfahrens kann aus den aufgenommenen Daten dann eine Lageinformation zu den durch den Lichtpunkt überstrichenen Bereichen ermittelt werden.

Weiterhin kann das Laserlicht auch als linienförmigen Laserstrahl ausgebildet sein. In diesem Fall werden zumindest Teile einer Ebene von dem ausgestrahlten Laserlicht aufgespannt. Auf einer Oberfläche, beispielsweise des Bauelements und/oder den Bauelementanschlüssen, entsteht damit ein linienförmiger Beleuchtungsstreifen.

Diese Ausgestaltung hat den Vorteil, dass zur Abrasterung von relevanten Kontaktflächen von Bauelementanschlüssen im Allgemeinen nur eine eindimensionale Bewegung notwendig ist, was den Aufwand und die Zeit zur Aufnahme der Daten reduziert, die zur Lagebestimmung der Bauelementanschlüsse verwendet werden.

Die Kamera kann beispielsweise auch eine Matrix- oder Flächenkamera ausgebildet sein. Als lichtempfindlichen Sensor kann eine solche Kamera dann z.B. einen Matrix- oder Flächensensor umfassen. Eine solche Kamera mit einer Matrix- oder Flächenkamera ist insbesondere im Zusammenhang mit der Verwendung eines linienförmigen Laserstrahls gemäß der vorstehenden Beschreibung vorteilhaft.

Zur Aufnahme der Bilddaten kann beispielsweise bei der Verwendung eines linienförmigen Laserstrahls und einer Matrix- oder Flächenkamera das Bauelement relativ zu Kamera und Laser in einer eindimensionalen, insbesondere einer linearen Bewegung verschoben werden.

Zur Bestimmung der Lage der Bauelementanschlüsse, insbesondere von Kontaktbereichen der Bauelementanschlüsse aus den von der Kamera aufgenommenen Bilddaten kann z.B. ein so genanntes Triangulationsverfahren verwendet werden. Mittels eines solchen Verfahrens lassen sich beispielsweise besonders einfach aus der bekannten Aussende-Richtung des Laserlichts und/oder der Lage des Lasers sowie der bekannten Position der Kamera die räumliche Lage von Oberflächenbereichen oder -punkten des Bauelements oder der Bauelementanschlüsse ermitteln. Daher kann die Bildauswerteeinrichtung vorteilhafterweise zur Durchführung eines solchen Verfahrens unter Verwendung der aufgenommenen Daten ausgebildet sein.

Die Bildauswerteeinrichtung kann z.B. als externes Gerät oder in einem externen Gerät wie beispielsweise einem Computer oder einem Computermodul ausgebildet sein. Die Bildauswerteeinrichtung kann sich aber auch zumindest teilweise in der Kamera bzw. im Kameragehäuse selbst befinden. So kann beispielsweise eine Vorverarbeitung und Auswahl der Bilddaten direkt in einem Gehäuse der Kamera erfolgen. Diese Daten können dann z.B. an eine Nachauswerteeinrichtung, beispielsweise einen Computer, zur weiteren Auswertung und beispielsweise auch Darstellung der Daten gegeben werden.

Zur Vermessung von Bauelementanschlüssen eines Bauelements kann das Bauelement beispielsweise innerhalb der Vorrichtung beweglich gelagert sein. So kann das Bauelement beispielsweise innerhalb der Vorrichtung derart gelagert sein, das es sich innerhalb einer Ebene so bewegen lässt, dass alle Bauelementanschlüsse, oder alle relevanten Bauelementanschlüsse, vom Laser beleuchtet werden können.

Weiterhin kann das Bauelement auch innerhalb der Vorrichtung derart gelagert sein, dass es sich nur in einer linearen Richtung bewegen lässt, beispielsweise entlang einer Linearführung. Diese Ausbildung der Vorrichtung eignet sich beispielsweise zur Verwendung eines linienförmigen Laserstrahls, welches derart ausgebildet ist, dass alle relevanten Bereiche des Bauelements und dessen Anschlüsse in einer Dimension vollständig vom Laserlicht beleuchtet werden, so dass mittels einer Bewegung des Bauelements in einer anderen Richtung als der Richtung der Laserlinie, z.B. in einer Richtung senkrecht dazu, sukzessive alle relevanten Bereiche des Bauelements und dessen Anschlüssen beleuchtbar sind bzw. beleuchtet werden.

Dabei kann jeweils vorgesehen sein, dass Laser und Kamera innerhalb der Vorrichtung fixiert sind.

Weiterhin kann die Vorrichtung aber auch derart ausgebildet sein, dass das Bauelement fixiert ist und sich Laser und Kamera entsprechend bewegen.

Die vorstehend genannte Aufgabe wird auch gelöst durch ein Verfahren zur Lagevermessung von Bauelementanschlüssen eines Bauelements unter Verwendung einer Vorrichtung gemäß der vorstehenden Beschreibung, wobei
das Laserlicht in Richtung zumindest eines der Bauelementanschlüsse ausgesendet wird,
mittels der Kamera Bilddaten des rückgestreuten Lichts aufgenommen werden, und
aus den Bilddaten die Lage des zumindest einem der Bauelementanschlüsse ermittelt wird.

Dabei wird durch die Verwendung der vorstehend genannten Vorrichtung zur Durchführung des Verfahrens erreicht, dass das Auftreten von Reflexen des ausgestrahlten Laserlichts in die Kamera reduziert wird.

Die vorstehend erläuterte Erfindung soll nun anhand der folgenden Zeichnungen beispielhaft näher erläutert werden. Es zeigt:
Figur 1: Beispiel für eine Vorrichtung zur Vermessung von Bauelementanschlüssen;
Figur 2: Beispielhafte Anordnung zur Vermessung von Bauelementanschlüssen gemäß der vorliegenden Erfindung.
Figur 3: Beispiele von Daten wie sie mit der in Figur 2 dargestellten Vorrichtung aufgenommen werden können und deren Weiterverarbeitung;
Figur 4: Geometrische Darstellung eines beispielhaften Strahlverlaufs bei der Beleuchtung einer kugelförmigen Oberfläche;
Figur 5: Beispielhafte Anordung von Laser und Kamera zur Ermittlung von Bilddaten eines Bauelementanschlusses mit kugelförmiger Oberfläche.

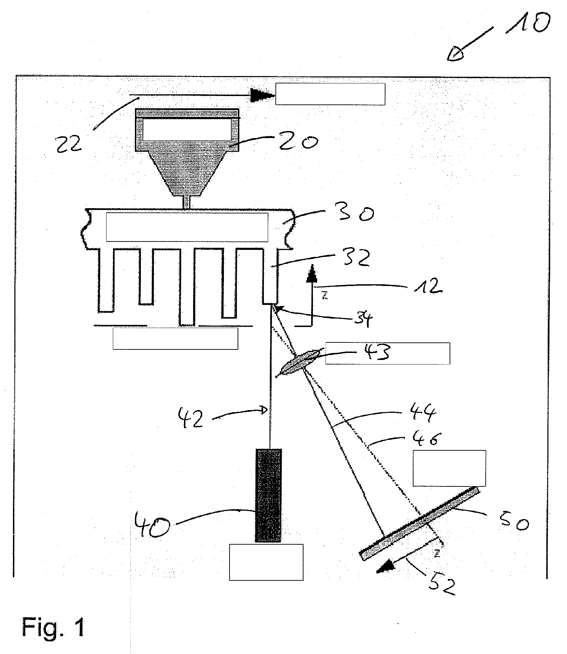

Figur 1 zeigt eine Triangulations-Sensoranordnung 10 mit einem Bauelement 30, welches von einem Bestückkopf 20 eines Bestückautomaten gehalten wird. Der Bestückkopf ist dabei unter anderem in eine Pfeilrichtung 22 bewegbar. Das Bauelement 30 hat mehrere Bauelelement-Anschlüsse, von welchen ein Bauelementanschluss 32 in Figur 1 von einem Laser 40 beleuchtet wird. Dabei trifft ein vom Laser 40 ausgestrahlter Laserstahl 42 eine Kontaktfläche 34 des Bauelementanschlusses 32. Von der Kontaktfläche gestreutes Licht 44 wird über eine Linse 43 auf eine Detektoreinrichtung 50 einer Kamera geleitet.

Hätte der Anschluss 32 in Richtung zum Pfeil 12 eine andere Ausdehnung, so würde das dann gestreute Licht beispielsweise einen Verlauf 46 haben und auf einen anderen Ort der Detektoreinrichtung 50 treffen. Dieser andere Ort ist in Pfeilrichtung 52 verschoben. Daher kann aufgrund der Lage des Auftreffpunktes des gestreuten Lichts auf dem Detektor 50 auf die räumliche Lage der Kontaktfläche 34 geschlossen werden.

Wie in Figur 1 dargestellt, sind beim Lasertriangulationssensor Laser 40 und Detektor 50 in einem bestimmten Winkel zueinander angeordnet. Der Detektor 50 sieht den diffusen Reflex 44 des Lasers 40 auf dem Anschluss des Bauelementes. Unterschiedliche Höhen der Anschlüsse bilden sich im Detektor durch seitliche Verschiebungen ab.

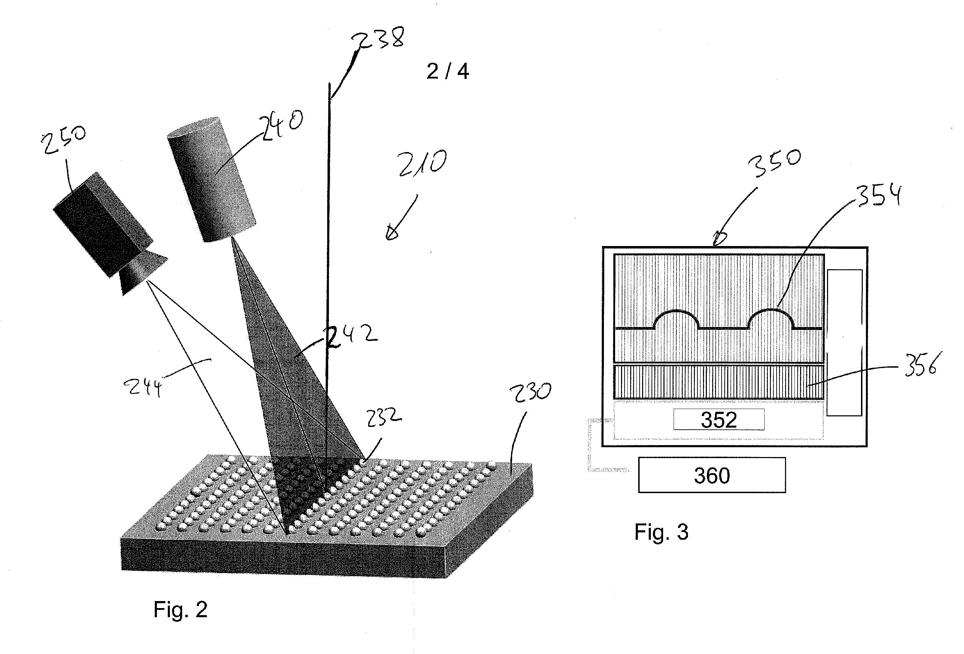

Die Bestimmung der Koplanarität von so genannten BGAs (Ball Grid Array) ist mit diesem Sensor relativ langsam oder zeiteffizient nicht möglich. Laser und Detektor können aber um eine Dimension erweitert werden, d.h. aus dem Laserpunkt wird eine Laserlinie, aus dem Zeilendetektor wird ein Flächendetektor. Durch Bewegen des Bauelementes senkrecht zur Laserlinie eines solchen Sensors entsteht dann ein echtes 3D-Profil (siehe Figuren 2 und 3).

Figur 2 zeigt eine Anordnung 210 umfassend ein Bauelement 230 mit Bauelementanschlüssen 232, wobei aus Gründen der Übersichtlichkeit nur einer der Anschlüsse 232 in Figur 2 bezeichnet ist. Die Anschlüsse 232 sind als metallische Kugeln oder Halbkugeln, so genannte "Balls" ausgebildet. Die Anordnung der Anschlüsse 232 ist ein so genanntes "Ball Grid Array".

Die Anordnung 210 umfasst weiterhin einen Laser 240, der einen linienförmigen Laserstahl 242 aussendet. Der Laserstrahl 240 beleuchtet eine Linie auf einer Unterseite des Bauelement 230 und eine Anzahl von Kontakten 232. Von dieser Linie gestreutes Licht 244 wird auf eine Detektoreinrichtung einer Kamera 250 geleitet und auf dieser Detektoreinrichtung ebenfalls als Linie abgebildet. Die Form der Linie auf der Detektoreinrichtung ist charakteristisch für das beleuchtete Oberflächenprofil.

In Figur 2 ist erkennbar, dass der Laser 240 und die Kamera 250 auf einer Seite einer Mittelachse 238, die eine Oberflächennormale 238 zur Unterseite des Bauelements 230 ist, angeordnet sind.

Figur 3 zeigt die Struktur einer Auswerteeinheit 350 zur in Figur 2 dargestellten Anordnung 210. Die von der Kamera 250 aufgenommenen Höhendaten werden dort abgelegt, was als Linie 354 in Figur 3 symbolisiert ist. Die Daten werden dann in einem Auswertemodul 356 ausgewertet und als Höhendaten 360 über eine Ein-/Ausgabschnittstelle 352 zur weiteren Analyse und/oder Darstellung ausgegeben.

Auf Basis des ermittelten 3D-Profils wird durch den Fit einer geeigneten Modellbeschreibung (bei einem BGA-Anschluss typischer Weise eine Kugel) die Höhe des Anschlusses berechnet. Dieser Schritt ist notwendig, um den Einfluss von statistischem Rauschen und kleinerer Oberflächenschäden (Kratzer) auf die Messergebnisse zu reduzieren. Entscheidend für die Qualität der Höhenergebnisse sind die Rohdaten:
- Diese sollten wenig systematische Höhenabweichungen aufweisen.
- Pro Anschluss sollten möglichst viele Datenpunkte vorliegen
- Die Verteilung der Datenpunkte sollte möglichst symmetrisch über den Anschluss verteilt sein.

Wie bereits erwähnt, benutzt das Triangulationsprinzip die diffuse Reflexion der Oberfläche des Anschlusses. Wird der Laser direkt in den Sensor gespiegelt, so führt dies
(i) zu einer, oft extremen, Übersteuerung
(ii)zu einer Deformation des Signalpeaks und somit zu verfälschten Höheninformationen.
Das erhaltene Höhensignal ist für dieses Oberflächenelement nur beschränkt brauchbar. Es gilt also, wenn möglich spiegelnde Reflexionen zu vermeiden.

Durch den Einsatz von Polfiltern können spiegelnde Reflexe zwar relativ gut unterdrückt werden, leider wird der diffuse Reflex aber ebenfalls deutlich geschwächt, so dass dann nicht mehr genug Licht für die Messung bleibt. Polarisationsfilter mit einem hohen Polarisierungsgrad sind zudem sehr teuer.

Unabhängig davon, wie man Laser und Kamera zueinander anordnet - auf einer Kugeloberfläche (wie sie z.B. BGA-Balls aufweisen) - , gibt es immer ein Oberflächenelement mit dem richtigen Winkel für eine spiegelnde Reflexion. Es gibt nun zwei übliche Anordnungen von Laser und Kamera in Bezug auf das Objekt, nämlich Kamera von oben, Laser von der Seite und umgekehrt.

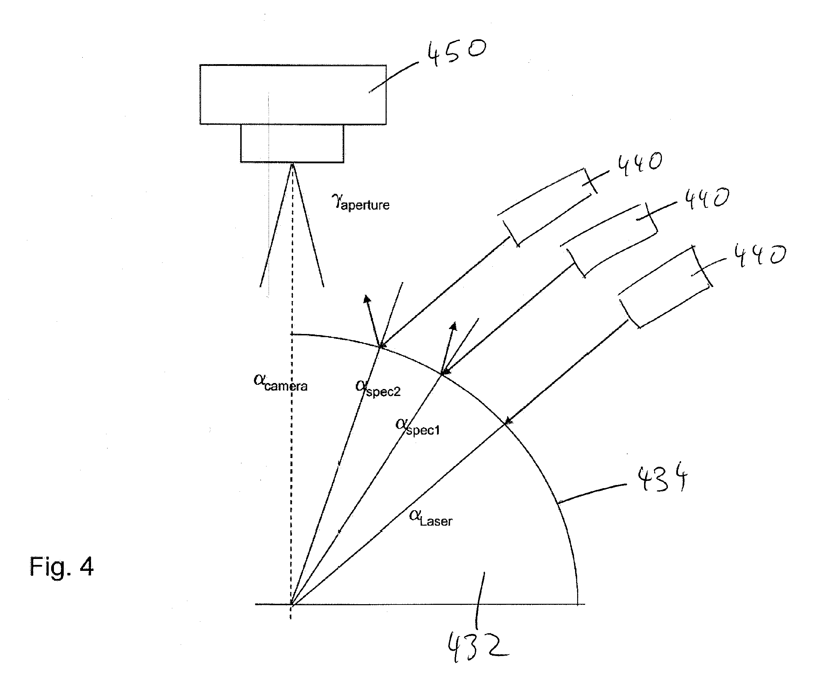

Figur 4 zeigt eine Anordnung, bei der eine Kamera 450 aus 90° und ein Laser 440 aus 45° auf eine Oberfläche 434 einer Kugel 432 schaut. Hätte die Kamera einen Öffnungswinkel von 0° und die Laserlinie eine unendlich kleine Breite, so würde es auf der Kugel nur einen Winkel geben, bei dem spiegelnde Reflexion auftritt ((90° + 45°)/2 = 72,5°).

Der Öffnungswinkel des Kameraobjektives bewirkt nun aber, dass sie nicht nur Strahlen sieht, die sie unter exakt 90° treffen, sondern auch umliegende. Damit vergrößert sich der spiegelnde Bereich um Öffnungswinkel/2. In Figur 4 ist das der Bereich, der durch die Winkel αspec1 und αspec2 begrenzt wird.

In vielen praktischen Fällen kann der verwendete Laserstrahl gegenüber einer Kontakt-Kugel nicht als klein angenommen werden (Kugelradius z.B. 200µm, Laserstrichbreite im Focus z.B. 30µm (Halbwertbreite bei gaussförmigem Profil)). Der Laser trifft also meist nicht nur auf ein einziges Oberflächenelement (mit einer einzigen Flächennormale), sondern auf einen ganzen Bereich. Dann gibt es auch nicht nur eine einzige Reflexionsrichtung; der Laser wird vielmehr aufgefächert (zur Verdeutlichung des Effektes betrachte man die drei von den Lasern 440 kommenden Linien in Figur 4 nicht als Einzelstrahlen, sondern als die Ausdehnung eines Laserstrahls). Die untere Hälfte des Strahles würde nicht zur Spiegelung beitragen, die obere schon.)

Zusätzlich hat üblicherweise auch ein Laser einen Öffnungswinkel, der in diesem Anwendungsfall aber im Allgemeinen vernachlässigbar ist. Berücksichtigt werden sollte aber der Randbereich des Lasers, da schon ein sehr kleiner Anteil direkt reflektierter Strahlung zu einem beträchtlichen Signalanteil auf dem Bildaufnehmer der Kamera führen kann. Der direkt reflektierte Signalanteil sollte aber idealer Weise vernachlässigbar klein sein gegenüber dem diffus reflektierten.

Addiert man diese beiden Effekte, ergibt sich ein größerer Bereich, in dem spiegelnde Reflexion auftritt, d.h. von dem keine genauen Höhenwerte zu erwarten sind. Bei der in Figur 4 gezeigten Anordnung liegt dieser Bereich ausgerechnet nahe der Ballkuppe. Die Ballkuppe ist aber für die Höhenbestimmung der Bauelementanschlüsse des BGAs wesentlich.

Der Bereich des Balls 434 aus Figur 4, der unterhalb von αspec1 liegt, liefert gute Höhenwerte, da hier keine spiegelnde Reflexion auftreten kann. Vom ganz unteren Bereich des Balls kommen möglicherweise keine Werte, weil die Kamera eventuell durch den Ball selbst abgeschattet wird. Der Bereich der "guten" Datenpunkte wird also auf der einen Seite durch Abschattung, auf der anderen Seite durch spiegelnde Reflexion begrenzt.

Da für eine Koplanaritätsauswertung vor allem die Höhenwerte an der Kuppe des Balls relevant sind, kann dieser Bereich bevorzugt so gedreht werden, dass er zu ihr symmetrisch liegt. Damit ergeben sich folgende Vorteile:
- Die Höhenwerte werden weniger systematisch durch die direkte Reflexion verfälscht.
- Die Anzahl der Stützstellen pro Anschluss wird verbessert.
- Die Verteilung der Datenpunkte ist symmetrischer über den Anschluss verteilt

Laser und Sensor werden so angeordnet, dass in einem möglichst großen Bereich um die kritische Ball-Kuppe keine spiegelnde Reflexion auftritt. Laser und Kamera liegen dabei auf einer Seite (in Bezug zur Senkrechten zur Transportrichtung des Bauelementes). Der optimale Kippwinkel ist abhängig von den oben aufgeführten Parametern (Strichbreite Laser, Apertur Kamera, Durchmesser des Anschlussballs) und wird zwischen 12,5 Grad für den Fall eines idealen Strichlasers und ca. 20 Grad für eine Anwendung mit Ballradius 200µm und relevanter Breite der Laserlinie von 60µm.

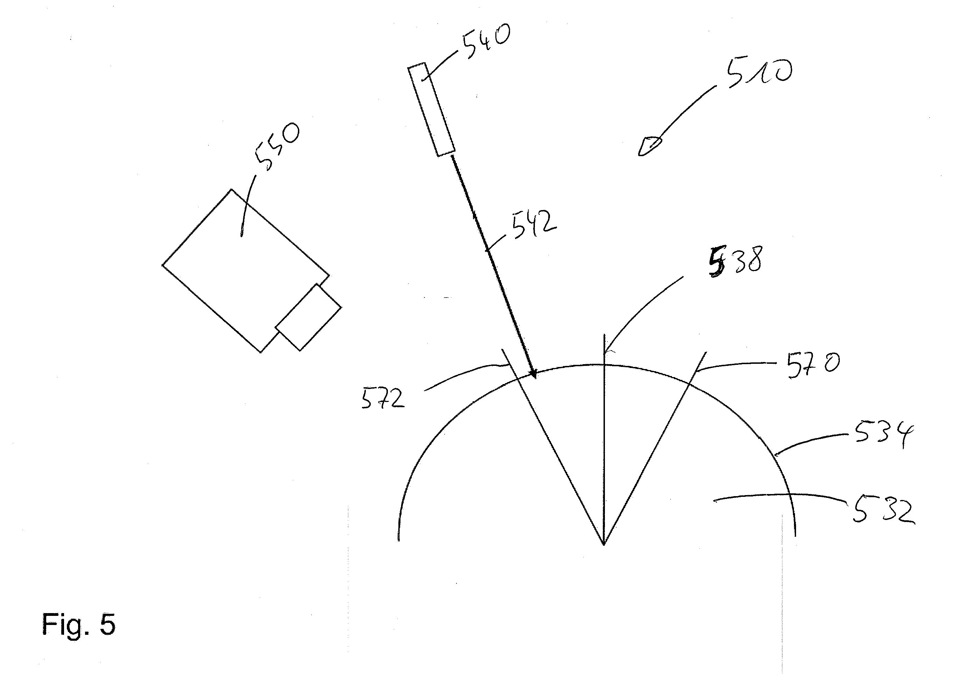

Figur 5 zeigt eine gegenüber der in Figur 4 dargestellten verbesserte Anordnung 510 zur Lagevermessung von Bauelementanschlüssen. Dabei wird Laserlicht 542 von einem Laser 540 in Richtung auf die Oberfläche 534 einer Kontaktkugel 532 ausgesandt. Mit einer Kamera 550 wird von der Oberfläche 534 der Kugel gestreutes Licht aufgenommen.

Durch die Anordnung von Kamera 550 und Laser 540 auf einer Seite einer Oberflächennormalen 538 können bessere Daten eines oberen Kontaktbereichs der Kugeloberfläche 534 aufgenommen werden. So zeigt Figur 5 eine Grenze der spiegelnden Reflexion 572 und eine Grenze der Abschattung 570, die derart liegen, dass der für die Kontaktierung relevanteste Kuppenbereich der Kugel 532 von der Kamera 550 ohne störende Reflexionen und mit genügend Streulicht aufgenommen werden kann.

Die in Figur 5 dargestellte Oberflächennormale 538 des Bauelementanschlusses 532 ist auch eine Rotationssymmetrieachse des kugelförmigen Bauelementanschlusses 532.

Nach mit der in Figur 5 gezeigten Anordnung kann ein 3D-Sensor aufgebaut werden, mit dem die Koplanarität von BGAs und Leaded-Bauteilen (in Bestückmaschinen) bestimmt werden kann.

## Patentansprüche

1. Verfahren zur Lagevermessung, insbesondere zur Koplanaritätsmessung von Bauelementanschlüssen (32, 232, 432, 532), bei dem
- mittels eines Lasers (40, 240, 440, 540) ein Laserstrahl (42, 242, 542) in Richtung der Bauelementanschlüsse (32, 232, 432, 532) ausgestrahlt wird,
- mittels einer Kamera (50, 250, 450, 550) von den Bauelementanschlüssen (32, 232, 432, 532) rückgestreutes Licht (44, 244) aufgenommen wird und daraus die Koplanarität der Bauelementanschlüsse (32, 232, 432, 532) bestimmt wird,
- Kamera (50, 250, 450, 550) und Laser (40, 240, 440, 540) in Bezug auf eine Mittelachse (238, 538) der Bauelementanschlüsse (32, 232, 432, 532) auf einer Seite angeordnet werden, und zwar so, dass in einem möglichst großen Bereich um die Bauelementanschlüsse (32, 232, 432, 532) keine spiegelnde Reflexion auftritt.

2. Vorrichtung zur Lagevermessung (10, 210, 510), insbesondere zur Koplanaritätsmessung von Bauelementanschlüssen (32, 232, 432, 532),
- mit einem Laser (40, 240, 440, 540) zum Ausstrahlen eines Laserstrahls (42, 242, 542) in Richtung der Bauelementanschlüsse (32, 232, 432, 532),
- mit einer Kamera (50, 250, 450, 550) zum Aufnehmen von Bildern durch von den Bauelementanschlüssen (32, 232, 432, 532) rückgestreuten Lichts (44, 244),
- mit einer Bildauswerteeinrichtung (350) zur Koplanaritäts-überprüfung mittels der Bilder,
- wobei Laser (40, 240, 440, 540) und Kamera (50, 250, 450, 550) in Bezug auf eine Mittelachse (238, 538) der Bauelementanschlüssen (32, 232, 432, 532) auf einer Seite angeordnet sind, und zwar so, dass in einem möglichst großen Bereich um die Bauelementeanschlüsse (32, 232, 432, 532) keine spiegelnde Reflexion auftritt.

3. Vorrichtung zur Lagevermessung von Bauelementanschlüssen (32, 232, 432, 532) eines Bauelements (30, 230),
- mit einem Laser (40, 240, 440, 540) zum Ausstrahlen von Laserlicht (42, 242, 542), insbesondere eines Laserstrahls (42, 242, 542), in Richtung der Bauelementanschlüsse (32, 232, 432, 532),
- mit einer Kamera (50, 250, 450, 550) zum Aufnehmen von Bilddaten des von den Bauelementanschlüssen (32, 232, 432, 532) rückgestreuten Lichts (44, 244),
- mit einer Bildauswerteeinrichtung (350) zur Bestimmung der Lage der Bauelementanschlüsse (32, 232, 432, 532) mittels der Bilddaten, insbesondere zur Höhenbestimmung und/oder Koplanaritäts-Überprüfung der Bauelementanschlüsse (32, 232, 432, 532),
- wobei Laser (40, 240, 440, 540) und Kamera (50, 250, 450, 550) in Bezug auf eine Mittelachse (238, 538) der Bauelementanschlüsse (32, 232, 432, 532) oder in Bezug auf eine Oberflächennormale (238, 538) des Bauelements (30, 230) auf einer Seite angeordnet sind.

4. Vorrichtung nach Anspruch 3,
**dadurch gekennzeichnet,**
**dass** der Laser (40, 240, 440, 540) und die Kamera (50, 250, 450, 550) in Bezug auf eine Mittelachse (238, 538) der Bauelementanschlüsse (32, 232, 432, 532) oder in Bezug auf eine Oberflächennormale (238, 538) des Bauelements (30, 230) derart auf einer Seite angeordnet sind, dass zumindest aus einem Kontaktbereich der Bauelementanschlüsse (32, 232, 432, 532) keine spiegelnde Reflexion des ausgestrahlten Laserlichts (42, 242, 542) in die Kamera (50, 250, 450, 550) auftritt.

5. Vorrichtung nach einem der Ansprüche 3 oder 4,
**dadurch gekennzeichnet,**
**dass** das Laserlicht (42, 242, 542) als punktförmiger Laserstrahl (42, 542) ausgebildet ist.

6. Vorrichtung nach Anspruch 5,
**dadurch gekennzeichnet,**
**dass** die Kamera (50, 250, 450, 550) als Zeilenkamera (50, 250, 450, 550) ausgebildet ist.

7. Vorrichtung nach einem der Ansprüche 3 oder 4,
**dadurch gekennzeichnet,**
**dass** das Laserlicht (42, 242, 542) als linienförmiger Laserstrahl (42, 242, 542) ausgebildet ist.

8. Vorrichtung nach Anspruch 7,
**dadurch gekennzeichnet,**
**dass** die Kamera (50, 250, 450, 550) als Matrix- oder Flächenkamera (50, 250, 450, 550) ausgebildet ist.

9. Vorrichtung nach einem der Ansprüche 2 bis 8,
**dadurch gekennzeichnet,**
**dass** die Bildauswerteeinrichtung (350) derart ausgebildet und eingerichtet ist, dass die Bestimmung der Lage der Bauelementanschlüsse (32, 232, 432, 532), insbesondere die Höhenbestimmung und/oder Koplanaritäts-Überprüfung der Bauelementanschlüsse (32, 232, 432, 532), mittels eines Triangulationsverfahrens unter Verwendung der Bilddaten erfolgt.

10. Vorrichtung nach einem der Ansprüche 2 bis 9,
**dadurch gekennzeichnet,**
**dass** die Vorrichtung zur Vermessung von Kontaktbereichen mit gekrümmten Kontaktflächen ausgebildet und eingerichtet ist, insbesondere zur Vermessung von im wesentlichen kugelförmigen oder kugelabschnitts-förmigen Bauelementanschlüssen.

11. Vorrichtung nach einem der Ansprüche 2 bis 9,
**dadurch gekennzeichnet,**
**dass** die Vorrichtung zur Vermessung von Bauelementanschlüssen (32, 232, 432, 532) mit im wesentlichen ebenen Kontaktflächen ausgebildet und eingerichtet ist.

12. Vorrichtung nach einem der Ansprüche 2 bis 11,
**dadurch gekennzeichnet,**
**dass** zur Vermessung der Bauelementanschlüsse das Bauelement (30, 230) sowie der Laser (40, 240, 440, 540) und die Kamera (50, 250, 450, 550) relativ zueinander bewegbar angeordnet sind.

13. Vorrichtung nach einem der Ansprüche 2 bis 12,
**dadurch gekennzeichnet,**
**dass** der Laser (40, 240, 440, 540) und die Kamera innerhalb der Vorrichtung fixiert sind und das Bauelement (30, 230) relativ zum Laser (40, 240, 440, 540) und der Kamera (50, 250, 450, 550) bewegbar, insbesondere verschiebbar angeordnet ist.

14. Verfahren zur Lagevermessung von Bauelementanschlüssen (32, 232, 432, 532) eines Bauelements (30, 230) unter Verwendung einer Vorrichtung gemäß einem der Ansprüche 2 bis 13, wobei
- das Laserlicht (42, 242, 542) in Richtung zumindest eines der Bauelementanschlüsse (32, 232, 432, 532) ausgesendet wird,
- mittels der Kamera (50, 250, 450, 550) Bilddaten des rückgestreuten Lichts (44, 244) aufgenommen werden, und
- aus den Bilddaten die Lage des zumindest einen der Bauelementanschlüsse (32, 232, 432, 532) ermittelt wird.

15. Verfahren nach Anspruch 14,
**dadurch gekennzeichnet,**
**dass** während Aufnahme der Bilddaten das Bauelement (30, 230) relativ zur Kamera (50, 250, 450, 550) und dem Laser (40, 240, 440, 540) bewegt, insbesondere verschoben wird.

16. Verfahren nach Anspruch 13 oder 14,
**dadurch gekennzeichnet,**
**dass dadurch** die Lage mehrerer Bauelementanschlüsse(32, 232, 432, 532), insbesondere eine Aussage bezüglich ihrer Koplanarität, ermittelt wird.
